# EUROPEAN PATENT APPLICATION

(11) **EP 4 604 684 A2**
(43) Date of publication of application: **20.08.2025**
(21) Application number: 24219826.5
(22) Date of filing: 13.12.2024
(51) Int. Cl.: H05K 7/20

(54) **COLD PLATE WITH TEMPERATURE UNIFORMITY AND INTEGRATED COOLING BOSSES**

(30) Priority: 14.02.2024 US 202418441696
(71) Applicant: Hamilton Sundstrand Corporation, Charlotte, NC 28217-4578 (US)
(72) Inventor: BOURAS, Scott R., Rockford, IL (US); OFOEGBU, Chukwunyere, Elgin, IL (US); SHEPARD, Charles, DeKalb, IL (US); PAL, Debabrata, Hoffman Estates, IL (US)
(74) Representative: Dehns

(57) **Abstract**

A cold plate is provided and includes an additively manufactured integral components layered together to form a unitary body. The additively manufactured integral components include a cold plate body (150) having a region on which a power module is disposable and defining a first interior channel extending across the region in a first plane, a frame (160) to support the cold plate body (150) and a cooling boss (171, 172). The frame (160) defines a second interior channel communicative with the first interior channel and extends along a periphery of the cold plate body (150) in the first plane. The cooling boss (171, 172) is attached to the frame (160). The cooling boss (171, 172) defines a third interior channel communicative with the second channel and extends in a second plane transverse to the first plane.

## Description

### STATEMENT OF FEDERAL SUPPORT

This invention was made with government support under Government Contract No. 80GRC020F0166 awarded by NASA. The government has certain rights in the invention.

### BACKGROUND

Exemplary embodiments of the present disclosure relate generally to aircrafts and, in some embodiments, to a cold plate with temperature uniformity and integrated cooling bosses for an electrical power conversion and distribution system of an aircraft.

Aircraft electrical power conversion and distribution systems include many high-heat flux components. These include, but are not limited to, power modules and circuit breakers which form a critical part of aircraft electrical systems and associated components. As the aerospace industry evolves, power demands continue to increase. As such, power level capabilities of aircraft electrical power generation, conversion and distribution systems are also continuing to increase. This leads to increased heat dissipations of the power modules, bus bars and circuit breakers but the increased heat dissipations of these components tend to result in reduced reliability and premature wear out. Furthermore, power modules that are capable of the increased power levels tend to be relatively large and therefore more susceptible to temperature non-uniformity.

It has been found that current cooling solutions for the issues noted above may not be feasible, especially at increased power levels that are required for electrified propulsion and future high-power applications.

Accordingly, a continuing need exists for improvements in cooling solutions for power moules, bus bars and circuit breakers.

### BRIEF DESCRIPTION

According to an aspect of the disclosure, a cold plate is provided and includes an additively manufactured integral components layered together to form a unitary body. The additively manufactured integral components include a cold plate body having a region on which a power module is disposable and defining a first interior channel extending across the region in a first plane, a frame to support the cold plate body and a cooling boss. The frame defines a second interior channel communicative with the first interior channel and extends along a periphery of the cold plate body in the first plane. The cooling boss is attached to the frame. The cooling boss defines a third interior channel communicative with the second channel and extends in a second plane transverse to the first plane.

In accordance with additional or alternative embodiments, the cold plate body has two or more regions on which power modules are disposable and the cooling boss is provided as two or more cooling bosses attached to the frame and respectively defining third interior channels.

In accordance with additional or alternative embodiments, the additively manufactured integral components forming the unitary body further include an inlet defining an interior channel inlet communicative with at least an upstream region of the first interior channel and an outlet defining an interior channel outlet communicative with at least a downstream region of the first interior channel. The inlet and the outlet further define a flow direction through the first, second and third interior channel.

In accordance with additional or alternative embodiments, the cold plate body includes fins extending through the first interior channel.

In accordance with additional or alternative embodiments, the fins include pin fins that are angled along the flow direction to lean away from incoming flow.

In accordance with additional or alternative embodiments, fin spacings of the fins differ at different locations along the flow direction.

In accordance with additional or alternative embodiments, a fin spacing of the fins decreases along the flow direction.

In accordance with additional or alternative embodiments, the second plane is perpendicular to the first plane and the cooling boss includes a lower part below the first plane and an upper part above the first plane.

In accordance with additional or alternative embodiments, the lower part and the upper part are laterally offset from one another.

In accordance with additional or alternative embodiments, the lower part and the upper part each define U-shaped sections of the third interior channel.

In accordance with additional or alternative embodiments, the cooling boss defines the third interior channel as a serpentine channel.

According to an aspect of the disclosure, a cold plate assembly is provided and includes the cold plate, wherein the cold plate body has two or more regions on which power modules are disposable and the cooling boss is provided as two or more cooling bosses attached to the frame and respectively defining third interior channels, and at least one of a power module disposed on a corresponding one of the two or more regions, bus bar units disposed on a corresponding one of the two or more regions and a corresponding one of the two or more cooling bosses and a terminal block unit attached to a corresponding one of the two or more cooling bosses.

According to an aspect of the disclosure, a cold plate assembly is provided and includes additively manufactured integral components layered together to form a unitary body. The additively manufactured integral components include a cold plate body having a power module region and defining a first interior channel extending across the power module region in a first plane, a frame to support the cold plate body and a cooling boss. The frame defines a second interior channel communicative with the first interior channel and extends along a periphery of the cold plate body in the first plane. The cooling boss is attached to the frame. The cooling boss defines a third interior channel communicative with the second channel and extends in a second plane transverse to the first plane. The cold plate assembly further includes a power module disposed on the power module region, bus bar units disposed on the power module region and the cooling boss and a terminal block unit attached to the cooling boss.

In accordance with additional or alternative embodiments, the power module includes a metal-oxide-semiconductor field effect transistor (MOSFET) element.

In accordance with additional or alternative embodiments, the cold plate body has two or more power module regions and the cooling boss is provided as two or more cooling bosses attached to the frame and respectively defining third interior channels. The cold plate assembly further includes two or more power modules respectively disposed on the two or more power module regions, a divider disposed on the cold plate body between the two or more power module regions, first and second bus bar units disposed on the divider and the two or more cooling bosses, respectively, and two or more terminal blocks respectively attached to the two or more cooling bosses.

In accordance with additional or alternative embodiments, the additively manufactured integral components forming the unitary body further include an inlet defining an interior channel inlet communicative with at least an upstream region of the first interior channel and an outlet defining an interior channel outlet communicative with at least a downstream region of the first interior channel. The inlet and the outlet further define a flow direction through the first, second and third interior channels.

According to an aspect of the disclosure, a cold plate assembly fabrication method is provided and includes determining power modules, bus bars and terminal blocks to be disposed on or attached to the cold plate body, modeling temperatures of the cold plate body with the power modules, the bus bars and the terminal blocks disposed on or attached thereto and operating, iteratively redesigning the cold plate body and iteratively remodeling the temperatures to achieve a desired degree of temperature uniformity and additively manufacturing integral components to form the cold plate body as a unitary body once the desired degree of temperature uniformity is achieved.

In accordance with additional or alternative embodiments, the additively manufacturing of the integral components to form the cold plate body as the unitary body includes additively manufacturing a cold plate body having two or more regions on which two or more of the power modules are disposable and defining a first interior channel extending across the two or more regions in a first plane, additively manufacturing a frame to support the cold plate body, the frame defining a second interior channel communicative with the first interior channel and extending along a periphery of the cold plate body in the first plane, and additively manufacturing two or more cooling bosses attached to the frame and respectively defining two or more third interior channels communicative with the second channel and extending in a second plane transverse to the first plane.

In accordance with additional or alternative embodiments, the additively manufacturing of the integral components to form the cold plate body as the unitary body further includes additively manufacturing an inlet defining an interior channel inlet communicative with at least an upstream region of the first interior channel and additively manufacturing an outlet defining an interior channel outlet communicative with at least a downstream region of the first interior channel. The inlet and the outlet further define a flow direction through the first, second and third interior channels.

In accordance with additional or alternative embodiments, the additively manufacturing of the cold plate body includes building up fins extending through the first interior channel and at least one or more of the fins include pin fins that are angled along the flow direction to lean away from incoming flow, fin spacings of the fins differ at different locations along the flow direction and a fin spacing of the fins decreases along the flow direction.

In accordance with additional or alternative embodiments, the cold plate assembly fabrication method further includes respectively disposing the two or more power modules on the two or more power module regions, disposing a divider on the cold plate body between the two or more power module regions, disposing first and second bus bar units on the divider and the two or more cooling bosses, respectively, and respectively attaching two or more terminal blocks to the two or more cooling bosses.

These and other advantages and features will become more apparent from the following description taken in conjunction with the drawings.

### BRIEF DESCRIPTION OF THE DRAWINGS

The following descriptions should not be considered limiting in any way. With reference to the accompanying drawings, like elements are numbered alike:
FIG. 1 is a perspective view of a cold plate assembly in accordance with embodiments;
FIG. 2 is a top-down view of a cold plate of the cold plate assembly of FIG. 1 in accordance with embodiments;
FIG. 3 is an elevational view of a cold plate of the cold plate assembly of FIG. 1 in accordance with embodiments;
FIG. 4 is a skeletal view of the cold plate of FIGS. 2 and 3 and internal channels in accordance with embodiments; and
FIG. 5 is a flow diagram illustrating a cold plate assembly fabrication method in accordance with embodiments.
These and other advantages and features will become more apparent from the following description taken in conjunction with the drawings.

### DETAILED DESCRIPTION

A detailed description of one or more embodiments of the disclosed apparatus and method are presented herein by way of exemplification and not limitation with reference to the Figures.

As will be described below, an additively manufactured cold plate is provided that is characterized in that temperature uniformity can be achieved over a large surface area in combination with heat transfer enhancement via integrated locally cooled mounting bosses. Improved thermal management is achieved with fins oriented for optimum print quality, variable fin density, flow balancing and z-axis cooling features. Fin density can be varied in flow directions to enable temperature uniformity in the flow directions and flow restriction features can be implemented for flow balancing to achieve temperature uniformity in directions normal to the flow directions. Cooling passages can be implemented within bosses in the z-axis to improve heat transfer at critical mounting locations.

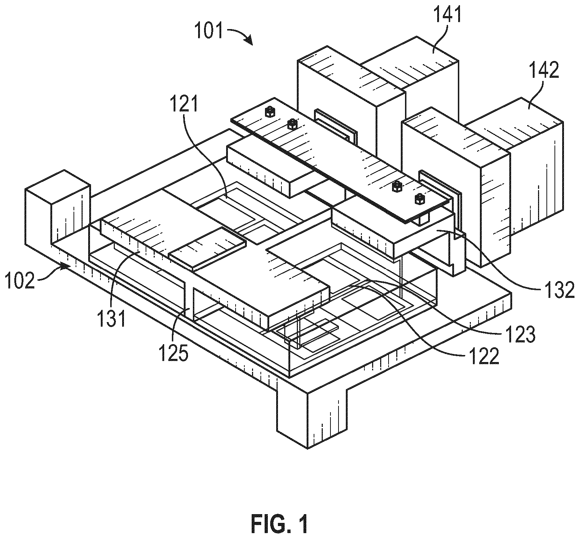

With reference to FIGS. 1-3, a cold plate assembly 101 is provided and may include additively manufactured integral components that are layered together or provided in a matrix to form a unitary body 102 (i.e., by one or more of material jetting, binder jetting, material extrusion, powder bed fusion, sheet lamination, directed energy deposition, etc.). The cold plate assembly 101 may further include two or more power modules 121, 122, a divider 125, first and second bus bar units 131, 132 and two or more terminal blocks 141, 142 (while this description relates to the case of the cold plate assembly 101 including the two or more power modules 121, 122, the first and second bus bar units 131, 132 and the two or more terminal blocks 141, 142, it is to be understood that this is done for purposes of clarity and brevity and that there could be fewer or greater numbers of each; unless otherwise noted, the following description will relate to these embodiments). At least one of the two or more power modules 121, 122 can include or be provided as a metal-oxide-semiconductor field effect transistor (MOSFET) element 123.

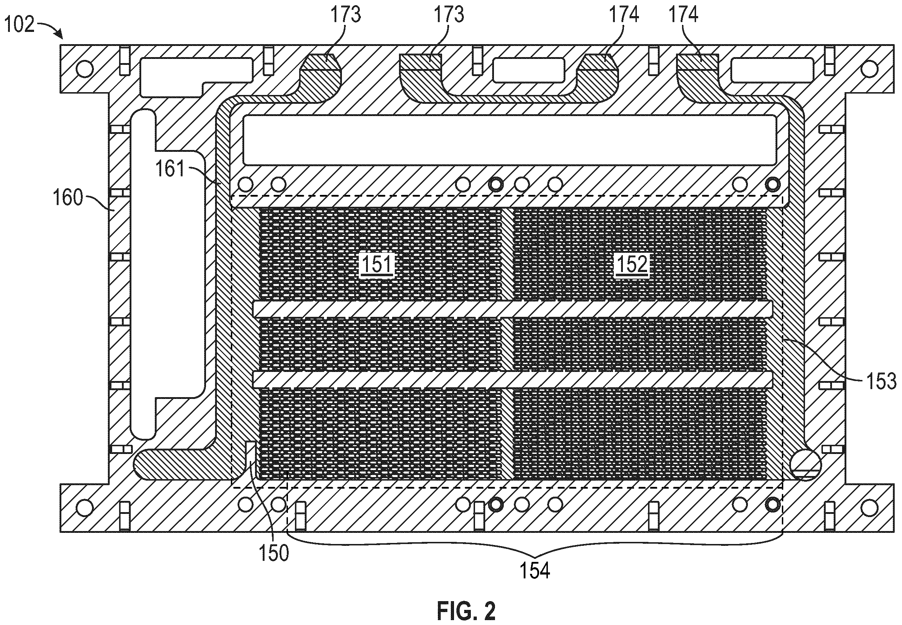

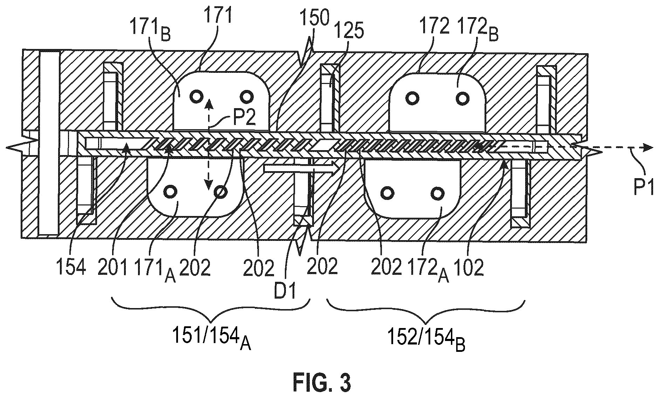

The additively manufactured integral components that are layered together or provided in a matrix to form the unitary body 102 may include a cold plate body 150, a frame 160 and two or more cooling bosses 171, 172. The cold plate body 150 can have two or more power module regions 151, 152 and a periphery 153 surrounding the two or more power module regions 151, 152. The cold plate body 150 can be formed to define a first interior channel 154 (see FIGS. 2 and 3), with second and third interior channels discussed below. The first interior channel 154 is extendible across the two or more power module regions 151, 152 in a first plane P1. The frame 160 is configured to support the cold plate body 150. The frame 160 can be formed to define a second interior channel 161 (see FIG. 2). The second interior channel 161 is fluidly communicative with the first interior channel 154. The second interior channel 161 is extendible along the periphery 153 of the cold plate body 150 in the first plane P1. The two or more cooling bosses 171, 172 can each be integrally attached to the frame 150. The two or more cooling bosses 171, 172 can both be formed to define third interior channels 173, 174, respectively. Each of the third interior channels 173, 174 is fluidly communicative with the second channel 161 and is extendible in a second plane P2, which can be transversely oriented or perpendicular relative to the first plane P1.

In an exemplary non-limiting embodiment, the two or more power modules 121, 122 can be respectively disposed on the two or more power module regions 151, 152, the divider 125 can be disposed on the cold plate body 150 between the two or more power module regions 121, 122, the first bus bar unit 131 can be disposed on the divider 125 and the second bus bar unit 132 can be disposed on the two or more cooling bosses 171, 172 and the two or more terminal blocks 141, 142 can be respectively attached to the two or more cooling bosses 171, 172.

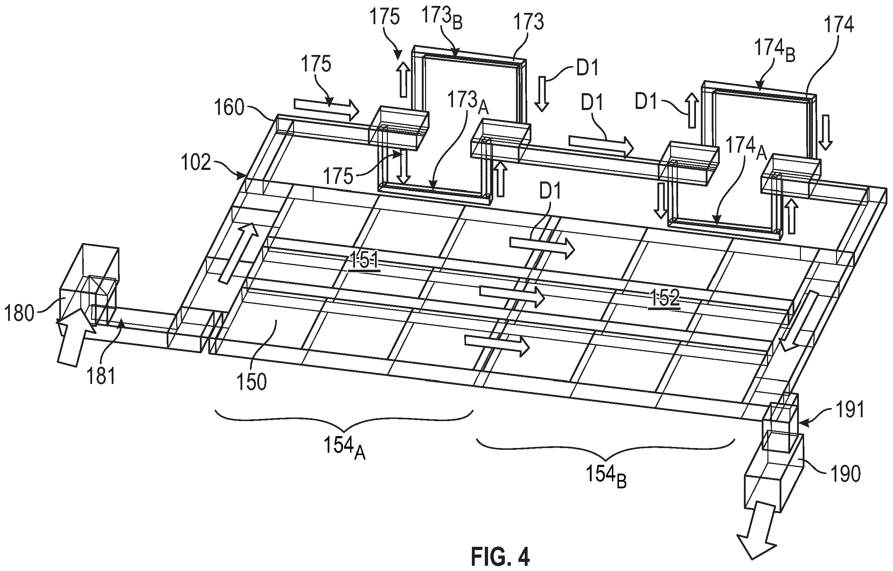

With continued reference to FIGS. 1-3 and with additional reference to FIG. 4, the additively manufactured integral components that are layered together or provided in a matrix to form the unitary body 102 can further include an inlet 180 and an outlet 190. The inlet 180 can be formed to define an interior channel inlet 181 that is fluidly communicative with at least an upstream region 154_{A} of the first interior channel 154, which is associated with and corresponds to power module region 151. The outlet 190 can be formed to define an interior channel outlet 191 that is fluidly communicative with at least a downstream region 154_{B} of the first interior channel 154, which is associated with and corresponds to power module region 152. The inlet 180 and the outlet 190 can further define a flow direction D1 of cooling fluid through the first interior channel 154, the second interior channel 161 and the third interior channels 173, 174.

In an exemplary non-limiting embodiment, the cold plate body 150 includes fins 201 that extend through the first interior channel 154. The fins 201 can include or be provided as pin fins 202 that are angled along the flow direction D1 to lean away from incoming flow, concentrations or fin spacings of the fins 201 can differ at different locations along the flow direction D1 and/or a concentration or fin spacing of the fins 201 can decrease or increase along the flow direction D1. Thus, during an operation of the unitary body 102, as fluid flows through the first interior channel 154, the second interior channel 161 and the third interior channels 173, 174, a temperature of the unitary body 102 can remain substantially uniform or constant. This can be achieved, at least partially, by a concentration or fin spacing of the fins 201 in the upstream region 154_{A} of the first interior channel 154 being decreased relative to a concentration or fin spacing of the fins 201 in the downstream region 154_{B} of the first interior channel 154. This can also be achieved, at least partially, by a concentration or fin spacing of the fins 201 increasing from the upstream region 154_{A} of the first interior channel 154 to the downstream region 154_{B} of the first interior channel 154.

As shown in FIG. 3, the two or more cooling bosses 171, 172 can each include a lower part 171_{A}, 172_{A} below the first plane P1 and an upper part 172_{A}, 172₂ above the first plane P1. For each of the two or more cooling bosses 171, 172, the lower part 171_{A}, 172_{A} and the upper part 171_{B}, 172₂ can be laterally offset from one another (i.e., left-to-right in the image of FIG. 3). In any case, the lower part 171_{A}, 172_{A} and the upper part 171_{B}, 172₂ can each define U-shaped sections 173_{A}, 173_{B} and 174_{A}, 174_{B} of the third interior channels 173, 174. Considered together, the two or more cooling bosses 171, 172 can define the third interior channels 173, 174 as a serpentine channel 175 (see FIG. 4).

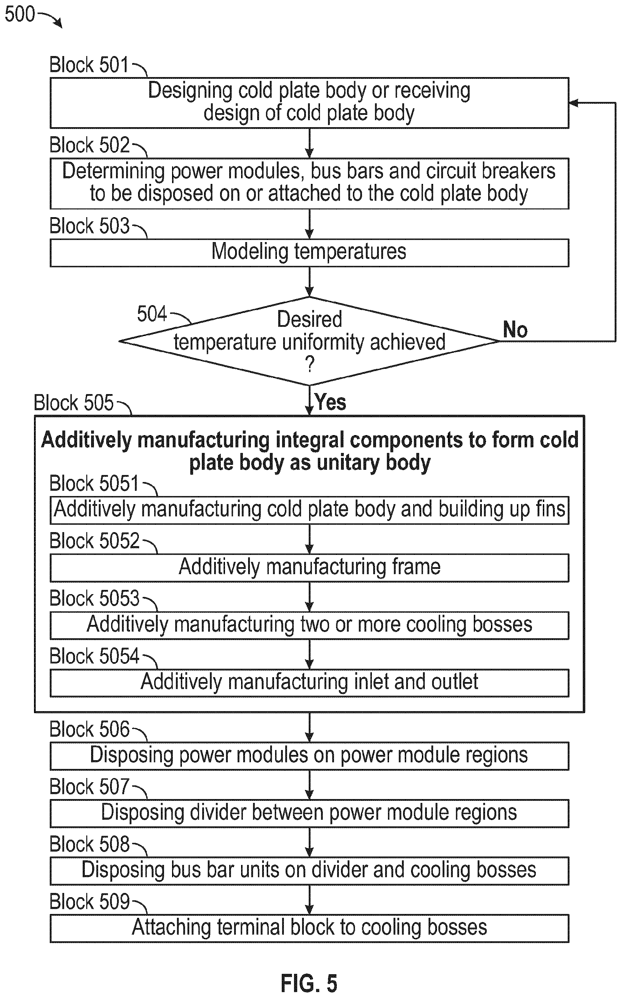

With reference to FIG. 5, a cold plate assembly fabrication method 500 is provided for manufacturing the cold plate assembly 101 described above for example. In an exemplary non-limiting embodiment, the cold plate assembly fabrication method 500 can include designing a cold plate body or receiving a design of the cold plate body (block 501), determining power modules, bus bars and terminal blocks to be disposed on or attached to the cold plate body (block 502) and modeling temperatures of the cold plate body with the power modules, the bus bars and the terminal blocks disposed on or attached thereto and operating (block 503). The cold plate assembly fabrication method 500 can also include determining whether a desired degree of temperature uniformity of the cold plate assembly is achieved (block 504) and, if not, iteratively redesigning the cold plate body (see block 501) and iteratively remodeling the temperatures (see block 503) to achieve the desired degree of the temperature uniformity. In an event the desired degree of the temperature uniformity is determined to be achieved in block 504, the cold plate assembly fabrication method 500 can further include additively manufacturing integral components to form the cold plate body as a unitary body (block 505).

The additively manufacturing of the integral components to form the cold plate body as the unitary body of block 505 can include additively manufacturing a cold plate body and building up fins as described above (block 5051), additively manufacturing a frame as described above (block 5052) and additively manufacturing two or more cooling bosses as described above (block 5053). In addition, the additively manufacturing of the integral components to form the cold plate body as the unitary body of block 505 can include additively manufacturing an inlet and an outlet as described above (block 5054) such that the inlet and the outlet define the flow direction D1. In each case, the additive manufacturing processes can include, but are not limited to, any type of three-dimensional (3D) printing, powder bed laser fusion (PBLF), etc.

With the cold plate body formed as the unitary body of block 505, the cold plate assembly fabrication method 500 can also include respectively disposing the two or more power modules on the two or more power module regions (block 506), disposing a divider on the cold plate body between the two or more power module regions (block 507) disposing first and second bus bar units on the divider and the two or more cooling bosses, respectively (block 508) and respectively attaching two or more terminal blocks to the two or more cooling bosses (block 509).

Technical effects and benefits of the features described herein are the provision of a cold plate that has improved temperature uniformity for improved power module reliability and integrated liquid cooled bosses for improved thermal management of cold plate mounted bus bars.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a", "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present disclosure has been described with reference to an exemplary embodiment or embodiments, it will be understood by those skilled in the art that various changes may be made and equivalents may be substituted for elements thereof without departing from the scope of the present disclosure. In addition, many modifications may be made to adapt a particular situation or material to the teachings of the present disclosure without departing from the essential scope thereof. Therefore, it is intended that the present disclosure not be limited to the particular embodiment disclosed as the best mode contemplated for carrying out this present disclosure, but that the present disclosure will include all embodiments falling within the scope of the claims.

## Claims

1. A cold plate, comprising:
additively manufactured integral components layered together to form a unitary body, comprising:
a cold plate body (150) having a region on which a power module is disposable and defining a first interior channel (154) extending across the region in a first plane;
a frame (160) to support the cold plate body (150), the frame (160) defining a second interior channel communicative with the first interior channel and extending along a periphery of the cold plate body (150) in the first plane; and
a cooling boss (171, 172) attached to the frame (160) and defining a third interior channel communicative with the second channel and extending in a second plane transverse to the first plane.

2. The cold plate according to claim 1, wherein the additively manufactured integral components forming the unitary body further comprise:
an inlet (180) defining an interior channel inlet communicative with at least an upstream region of the first interior channel; and
an outlet (190) defining an interior channel outlet communicative with at least a downstream region of the first interior channel,
wherein the inlet and the outlet further define a flow direction through the first, second and third interior channel.

3. The cold plate according to claim 2, wherein the cold plate body (150) comprises fins (201) extending through the first interior channel.

4. The cold plate according to claim 3, wherein the fins comprise pin fins that are angled along the flow direction to lean away from incoming flow.

5. The cold plate according to claim 3, wherein fin spacings of the fins differ at different locations along the flow direction, or wherein a fin spacing of the fins decreases along the flow direction.

6. The cold plate according to any preceding claim, wherein:
the second plane is perpendicular to the first plane, and
the cooling boss (171, 172) comprises a lower part below the first plane and an upper part above the first plane.

7. The cold plate according to claim 6, wherein the lower part and the upper part are laterally offset from one another, or wherein the lower part and the upper part each define U-shaped sections of the third interior channel.

8. The cold plate according to claim 6, wherein the cooling boss (171, 172) defines the third interior channel as a serpentine channel.

9. A cold plate assembly, comprising:
the cold plate according to any preceding claim, wherein the cold plate body (150) has two or more regions on which power modules are disposable and the cooling boss (171, 172) is provided as two or more cooling bosses attached to the frame (160) and respectively defining third interior channels; and
at least one of a power module disposed on a corresponding one of the two or more regions, bus bar units disposed on a corresponding one of the two or more regions and a corresponding one of the two or more cooling bosses and a terminal block unit attached to a corresponding one of the two or more cooling bosses.

10. A cold plate assembly, comprising:
additively manufactured integral components layered together to form a unitary body, comprising:
a cold plate body (150) having a power module region and defining a first interior channel extending across the power module region in a first plane;
a frame (160) to support the cold plate body (150), the frame (160) defining a second interior channel communicative with the first interior channel and extending along a periphery of the cold plate body (150) in the first plane; and
a cooling boss (171, 172) attached to the frame (160) and defining a third interior channel communicative with the second channel and extending in a second plane transverse to the first plane,
the cold plate assembly further comprising a power module disposed on the power module region, bus bar units disposed on the power module region and the cooling boss (171, 172) and a terminal block unit attached to the cooling boss (171, 172), and optionally wherein the power module comprises a metal-oxide-semiconductor field effect transistor "MOSFET" element.

11. The cold plate assembly according to claim 9, wherein:
the cold plate body (150) has two or more power module regions and the cooling boss (171, 172) is provided as two or more cooling bosses attached to the frame (160) and respectively defining third interior channels, and
the cold plate assembly further comprises:
two or more power modules respectively disposed on the two or more power module regions;
a divider disposed on the cold plate body (150) between the two or more power module regions;
first and second bus bar units disposed on the divider and the two or more cooling bosses, respectively; and
two or more terminal blocks respectively attached to the two or more cooling bosses, or wherein the additively manufactured integral components forming the unitary body further comprise:
an inlet defining an interior channel inlet communicative with at least an upstream region of the first interior channel; and
an outlet defining an interior channel outlet communicative with at least a downstream region of the first interior channel,
wherein the inlet and the outlet further define a flow direction through the first, second and third interior channels.

12. A cold plate assembly fabrication method, comprising:
determining power modules, bus bars and terminal blocks to be disposed on or attached to the cold plate body (150);
modeling temperatures of the cold plate body (150) with the power modules, the bus bars and the terminal blocks disposed on or attached thereto and operating;
iteratively redesigning the cold plate body (150) and iteratively remodeling the temperatures to achieve a desired degree of temperature uniformity; and
additively manufacturing integral components to form the cold plate body (150) as a unitary body once the desired degree of temperature uniformity is achieved.

13. The cold plate assembly fabrication method according to claim 12, wherein the additively manufacturing of the integral components to form the cold plate body (150) as the unitary body comprises:
additively manufacturing a cold plate body (150) having two or more regions on which two or more of the power modules are disposable and defining a first interior channel extending across the two or more regions in a first plane;
additively manufacturing a frame (160) to support the cold plate body (150), the frame (160) defining a second interior channel communicative with the first interior channel and extending along a periphery of the cold plate body (150) in the first plane; and
additively manufacturing two or more cooling bosses attached to the frame (160) and respectively defining two or more third interior channels communicative with the second channel and extending in a second plane transverse to the first plane.

14. The cold plate assembly fabrication method according to claim 13, wherein the additively manufacturing of the integral components to form the cold plate body (150) as the unitary body further comprises:
additively manufacturing an inlet defining an interior channel inlet communicative with at least an upstream region of the first interior channel; and
additively manufacturing an outlet defining an interior channel outlet communicative with at least a downstream region of the first interior channel,
wherein the inlet and the outlet further define a flow direction through the first, second and third interior channels, and optionally wherein:
the additively manufacturing of the cold plate body (150) comprises building up fins extending through the first interior channel, and
at least one or more of the fins comprise pin fins that are angled along the flow direction to lean away from incoming flow, fin spacings of the fins differ at different locations along the flow direction and a fin spacing of the fins decreases along the flow direction.

15. The cold plate assembly fabrication method according to claim 13, further comprising:
respectively disposing the two or more power modules on the two or more power module regions;
disposing a divider on the cold plate body (150) between the two or more power module regions;
disposing first and second bus bar units on the divider and the two or more cooling bosses, respectively; and
respectively attaching two or more terminal blocks to the two or more cooling bosses.
